# EUROPEAN PATENT APPLICATION

(11) **EP 1 699 281 A2**
(43) Date of publication of application: **06.09.2006**
(21) Application number: 06002651.5
(22) Date of filing: 09.02.2006
(51) Int. Cl.: H05K 7/14

(54) **Electronic appliance including a circuit board**

(30) Priority: 04.03.2005 JP 2005060203
(71) Applicant: Orion Electric Company, LTD., Echizen-shi, Fukui-ken (JP)
(72) Inventor: Sasaoka, Toshifumi, Ehizen-shi Fukui-ken (JP); Yonezu, Yoshikazu, Ehizen-shi Fukui-ken (JP); Yamamoto, Masateru, Ehizen-shi Fukui-ken (JP); Motonaga, Toru, Ehizen-shi Fukui-ken (JP)
(74) Representative: Kirschner, Klaus Dieter

(57) **Abstract**

A conventional problem is solved by: providing a guide rail 2 integrally molded in a housing 1 and vertical to a front face X of the housing 1 for inserting and holding one side end of a circuit board 5; forming through holes 7a, 7b, and 7c at positions which are opposite to the guide rail 2 so as to correspond to widths Wa, Wb, and Wc of circuit boards 5a, 5b, and 5c having different sizes; and further, mounting any of removable guide rail members 6a, 6b, and 6c which include engagement portions which can be engaged with the through holes 7a, 7b, and 7c of the housing 1.

## Description

### BACKGROUND OF THE INVENTION

### 1. Field of the Invention

The present invention relates to an electronic appliance including a circuit board. In particular, the present invention relates to a structure of mounting a circuit board configured in consideration of a case in which a housing that carries an appearance of the electronic appliance is equalized in size, and the size of the circuit board disposed inside of the housing is different depending on specification for the electronic appliance.

### 2. Description of the Related Art

Conventionally, a variety of structures have been used in order to mount circuit boards whose size and shapes are different from each other in a housing of an electronic appliance. In order to mount such circuit boards having different widths, for example, in Japanese Utility Model Registration No. 3076330, there is disclosed a housing of an electronic appliance having a circuit board mounting unit, wherein, when a circuit board is mounted in a housing, a first guide rail for inserting and guiding a first rim portion of the circuit board vertical to a front face of the housing and a second guide rail for inserting and guiding a second rim portion of the circuit board vertical to the front face of the housing, a length of the second guide rail from the housing front side being substantially one-third of that of the first guide rail, are integrally molded on a top face of a bottom part of the housing; and further, a board holder composed of other parts for supporting a rearward part of the second rim portion of the circuit board protruding from the second guide rail is provided in a predetermined plural sites of a top face of the bottom part of the housing in correspondence with shapes of the circuit boards having different widths.

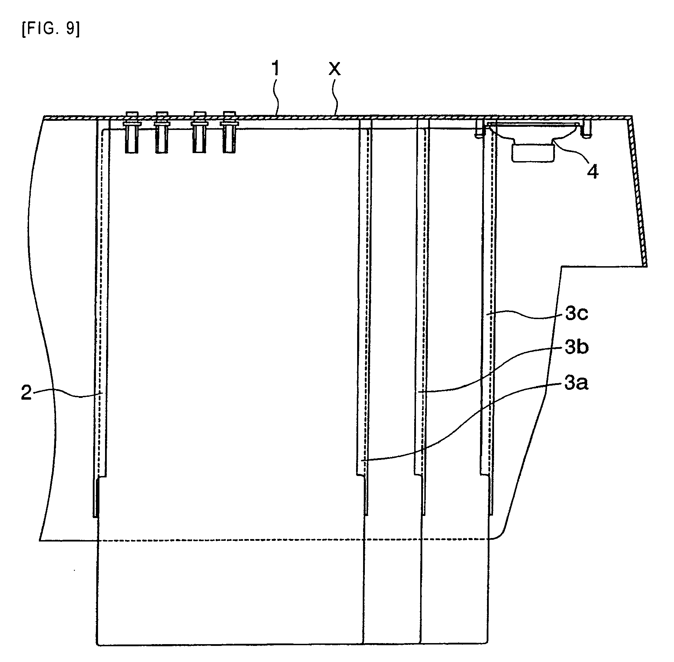

FIG. 9 is a sectional plan view showing an example of a housing of an electronic appliance having a circuit board mounting unit, which has been generally used conventionally. As shown in FIG. 9, in a housing 1, a first guide rail 2 for inserting and holding a first rim portion of a circuit board vertical to a front face X is integrally molded at one side of the housing 1, and further, a guide rail 3 for inserting and holding a second rim portion of the circuit board vertical to the front face X is integrally molded at the other side of the housing 1. Here, in the case where the size in the widthwise direction of the circuit board is changed due to a specification change for the electronic appliance or the like without changing the appearance and shape of the housing 1, a position at which the guide rail 3 is molded is changed by means of die bushing of the housing 1 to any of positions 3a, 3b, and 3c according to the size of the circuit board, as shown in FIG. 9, thereby mounting circuit boards having different sizes in the housing.

In the housing of the electronic appliance having the circuit board mounting unit disclosed in Japanese Utility Model Registration No. 3076330, a first guide rail for inserting and guiding a first rim portion of a circuit board vertical to a front face of a housing and a second guide rail for inserting and guiding a second rim portion of the circuit board vertical to the front face of the housing are integrally molded on the housing. Thus, there is a restriction that, when a circuit board is mounted in the housing, a length of one edge configuring a rim portion opposed to a housing front side of the circuit board is fixed to a specific value.

In the housing 1 of the electronic appliance having the circuit board mounting unit shown in FIG. 9, a specific bushing (not shown) according to the size of the circuit board must be additionally provided in a die for molding the housing 1, which causes a complicated die shape or shorter service life of die molding. In addition, only the molding positions of the guide rail 3 are different from each other in the housing 1 whose appearance and shape is identical, and thus, complication remains in the inventory control of the housing 1 on a board size-by-size basis, and further, there is a possibility that the housing 1 is molded while bushing is mistakenly selected. In addition, a position of mounting parts such as a speaker 4 and the like disposed on the front face side X of the housing 1 becomes an obstacle, and the guide rail 3c cannot be occasionally molded in the housing 1.

### SUMMARY OF THE INVENTION

The present invention has been made in order to solve the above-described problem associated with the conventional technique. It is an object of the present invention to provide a housing of an electronic appliance including a circuit board mounting structure which corresponds to circuit boards having different sizes.

In order to solve the above-described problems, the present invention provides an electronic appliance including a circuit board including: a housing which carries an appearance of the appliance; and a circuit board having mounted thereon a plurality of electronic parts disposed inside of the housing, wherein a first holding portion for holding one side end of the circuit board is integrally formed in the housing, and a second holding portion for holding the other side end of the circuit board is formed independently of the housing at a mount position opposed to the first holding portion in reference to a position at which the circuit board is disposed inside of the housing, the second holding portion enabled to change the mount position in a widthwise direction of the circuit board. Further, in the above-described electronic appliance including a circuit board, there is provided the electronic appliance including a circuit board, wherein a through hole is formed at a site at which the second holding portion is disposed in the housing, and an engagement portion is formed to be engaged with the through hole of the housing at the second holding portion, the second holding portion enabled to be removably mounted in the housing. Further, there is provided the electronic appliance including a circuit board, wherein a plurality of through holes to be formed in the housing are formed in the widthwise direction of the circuit board. Further, there is provided the electronic appliance including a circuit board, wherein a guide groove in which a side end of the circuit board slidably moves is formed in a depth direction of the circuit board at the second holding portion. Further, there is provided the electronic appliance including a circuit board, wherein the second holding portion is formed to be shorter in length than the first holding portion with respect to the depth direction of the circuit board disposed inside of the housing.

According to the present invention, there is provided a housing of an electronic appliance with high general versatility, wherein there is no need for additionally providing a specific bushing according to a specific size of a circuit board in correspondence with specification for the electronic appliance, while mounting the specific one of a plurality of circuit boards having different sizes in the electronic appliance having the housing of the same appearance and shape, and further, there is no need for providing a specific guide rail for receiving and guiding a rim portion of the circuit board, even in the case where parts such as a speaker and the like are disposed at a mount position at the front face side of the housing.

### BRIEF DESCRIPTION OF THE DRAWINGS

FIG. 1 is a sectional plan view showing an example of a housing and a removable guide rail member of an electronic appliance including a circuit board mounting structure in the present invention;
FIG. 2 is a sectional plan view showing an example of a housing and a removable guide rail member of an electronic appliance including a circuit board mounting structure in the present invention;
FIG. 3 is a sectional plan view showing a state before a circuit board having a small width is mounted in a housing to illustrate an embodiment of the present invention;
FIG. 4 is a sectional plan view showing a state after a circuit board having a small width is mounted in a housing to illustrate an embodiment of the present invention;
FIG. 5 is a sectional plan view showing a state before a circuit board having a middle width is mounted in a housing to illustrate an embodiment of the present invention;
FIG. 6 is a sectional plan view showing a state after a circuit board having a middle width is mounted in a housing to illustrate an embodiment of the present invention;
FIG. 7 is a sectional plan view showing a state before a circuit board having a large width is mounted in a housing to illustrate an embodiment of the present invention;
FIG. 8 is a sectional plan view showing a state after a circuit board having a large width is mounted in a housing to illustrate an embodiment of the present invention; and
FIG. 9 is a sectional plan view showing an example of a housing of an electronic appliance including a circuit board mounting structure generally used conventionally.

### DESCRIPTION OF THE PREFERRED EMBODIMENTS

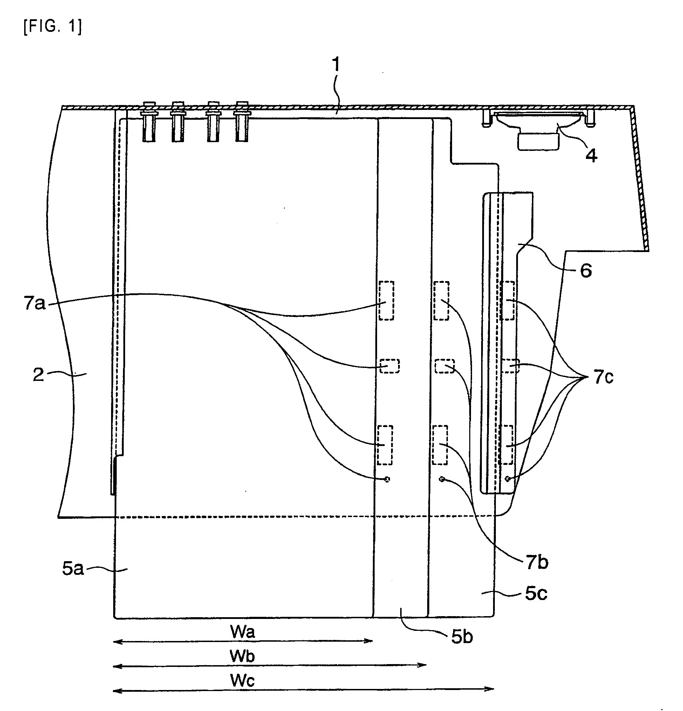

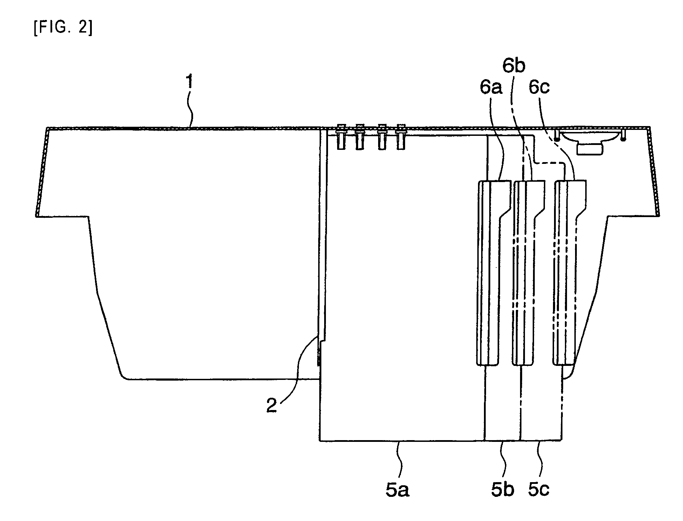

Hereinafter, specific embodiments of the present invention will be described with reference to the accompanying drawings. First, referring to FIGS. 1 and 2, there is shown a structure of a housing and a removable guide rail of an electronic appliance including a circuit board mounting structure in the embodiments according to the present invention. FIG. 1 shows a state in which circuit boards 5a, 5b, and 5c having different sizes in a widthwise direction are mounted in a housing 1 of the electronic appliance. For the sake of simplification of the description below, with respect to a circuit board 5 to be mounted, a small-width circuit board is defined as 5a, a middle-width circuit board is defined as 5b, and a large-width circuit board is defined as 5c according to their sizes. In the housing 1, a guide rail 2 for inserting and holding one side end of the circuit board vertical to a front face is provided by integrally molding it with the housing 1. At a position opposed to the guide rail 2 in reference to a position at which the circuit board 5 is disposed, through holes 7a, 7b, and 7c are formed so as to correspond to widths Wa, Wb, and Wc of the circuit boards 5a, 5b, and 5c having different sizes. Further, a guide rail member 6 including an engagement portion configured to be engaged with the through holes 7a, 7b, and 7c of the housing 1 can be removably mounted in any of the through holes 7a, 7b, and 7c according to the size of the circuit board 5. While a structure for engaging the guide rail member 6 with any of the through holes 7a, 7b, and 7c is not limited in particular, for example, there may be provided a structure of forming an elastically deformable hook-shaped engagement portion of which a claw portion is formed at a tip end, hereby engaging the engagement portion with any of the through holes 7a, 7b, and 7c. In addition, in FIG. 1, the through hole 7a corresponding to the width Wa of the small-width circuit board 5a and the through hole 7b corresponding to the width Wb of the middle-width circuit board 5b are hidden behind the middle-width circuit board 5b and the large-width circuit board 5c, respectively, and thus, these through holes are indicated by dotted lines.

FIG. 2, as is the case with FIG. 1, shows a structure of the housing 1 and the removable guide rail member 6 of an electronic appliance including a circuit board mounting structure, illustrating an embodiment of the present invention. In FIG. 2, there is shown a state of removable guide rail members 6a, 6b, and 6c mounted in the through holes 7a, 7b, and 7c provided in the housing 1 in correspondence with the mount positions of the circuit boards 5a, 5b, and 5c having different sizes. The small-width circuit board 5a and the removable guide rail member 6a for holding a side end of the circuit board 5a are indicated by the solid line; the middle-width circuit board 5b and the removable guide rail member 6b for holding a side end of the circuit board 5b are indicated by the chain line; and the large-width circuit board 5c and the removable guide rail member 6c for holding a side end of the circuit board 5c are indicated by the two-dot chain line.

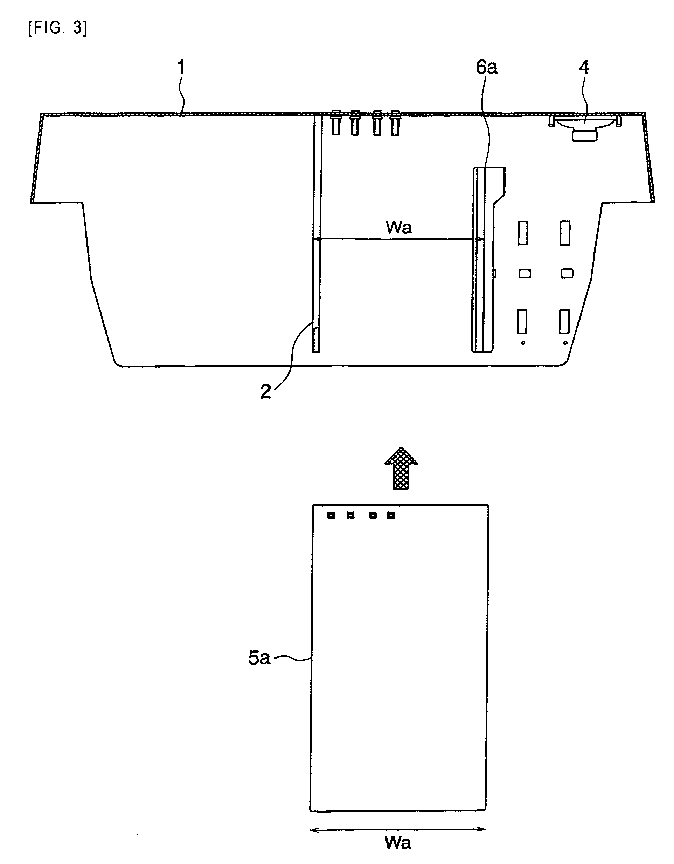

Based on the housing and removable guide rail members of the electronic appliance including the circuit board mounting structure described above, a description will be given below with respect to a method for mounting circuit boards having different sizes on a housing of the electronic appliance with reference to FIGS. 3 to 8.

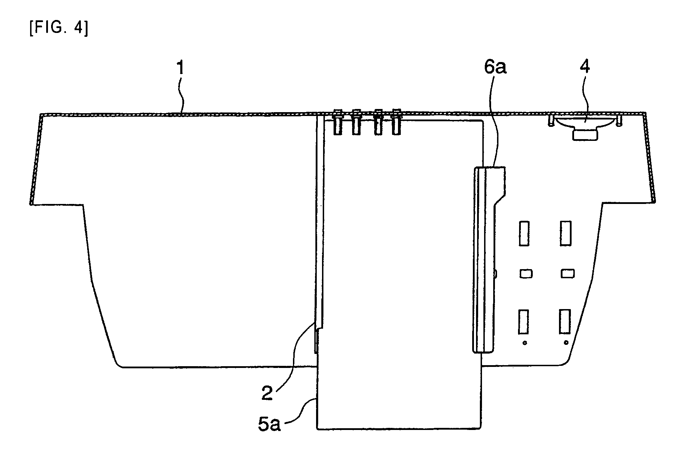

FIG. 3 is a sectional plan view showing a state before mounting the small-size circuit board 5a in the housing 1, and FIG. 4 is a sectional plan view showing a state after mounting the small-size circuit board 5a in the housing 1. Prior to mounting the small-size circuit board 5a in the housing 1, the removable guide rail member 6a is first mounted in the through hole 7a shown in FIG. 1 provided in a position spaced by a distance from the guide rail 2 integrally molded in the housing 1, the distance corresponding to the width Wa of the small-width circuit board 5a. In FIG. 3, there is shown a state in which the guide rail member 6a is mounted at a predetermined position of the housing 1. Next, both of the opposite rim portions of the small-width circuit board 5a to be mounted are inserted in the arrow direction of FIG. 3 along a guide groove formed inside of each guide rail by means of the guide rail 2 integrally molded in the housing 1 and the guide rail member 6a mounted in the through hole 7a. FIG. 4 shows a state in which the small-width circuit board 5a has been inserted into its predetermined position and is mounted in the housing 1 of the electronic appliance.

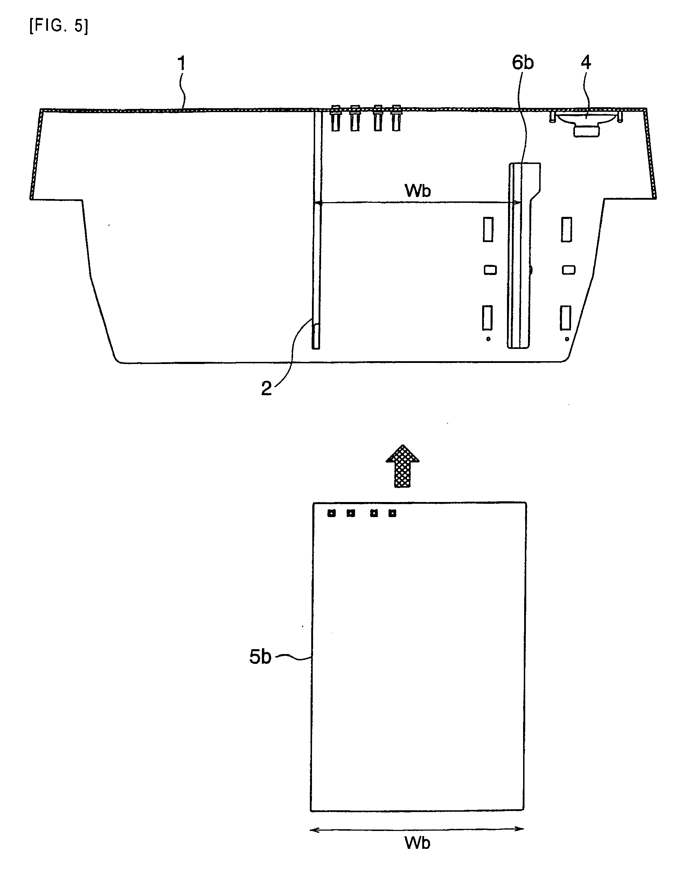

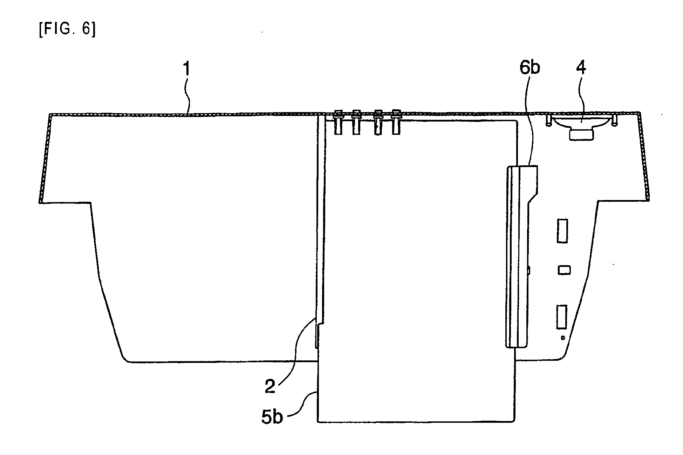

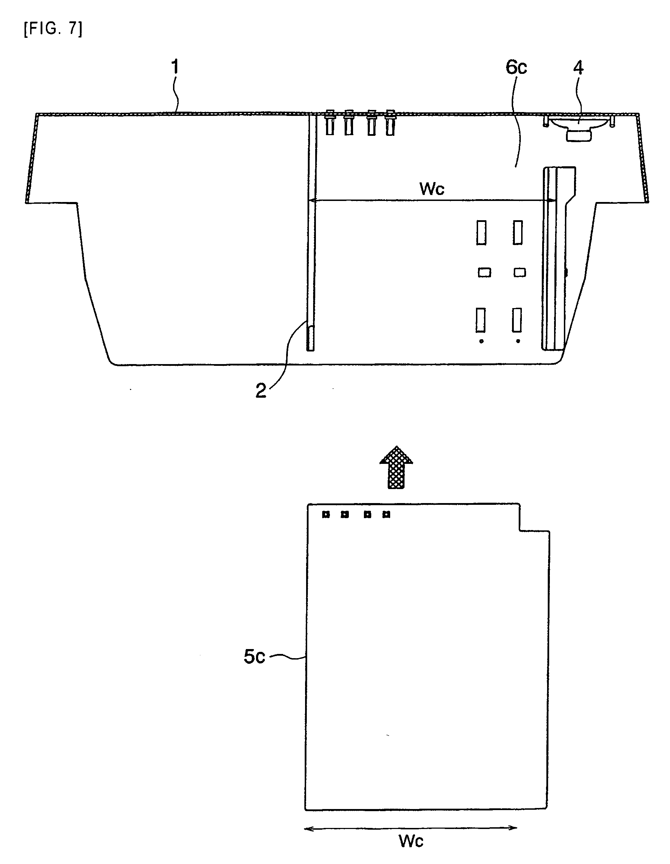

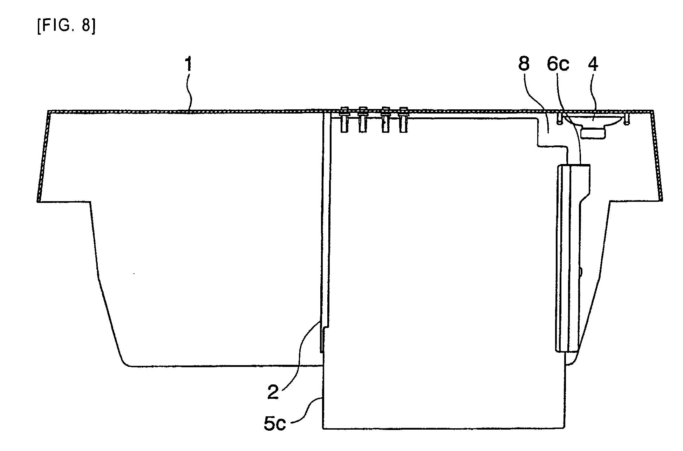

A description of a method for mounting the middle-width circuit board 5b and the large-width circuit board 5c in the housing 1 is identical to the above method for mounting the small-width circuit board 5a. Thus, a further description is omitted here for the sake of avoiding duplication. The method for mounting the middle-width circuit board 5b is shown in FIGS. 5 and 6, and the method for mounting the large-width circuit board 5c is shown in FIGS. 7 and 8, respectively.

While a problem associated with the conventional technique, i.e., a problem that the mount position of parts such as a speaker 4 and the like disposed at the front face side X of the housing 1 becomes an obstacle, and the guide rail 3c cannot be molded in the housing 1, has been previously described with reference to FIG. 1, the problem can be completely overcome by the present invention. A solution according to the present invention for solving the above-described problem will be described with reference to FIG. 8. In the present invention, a length of the removable guide rail member 6c is made smaller than that of the guide rail 2 integrally molded in the housing 1 and one corner 8 of the large-width circuit board 5c is cut out, and thereby, even when there are parts such as the speaker 4 and the like disposed inside of the housing 1, the large-width circuit board 5c can be mounted in the housing 1 smoothly without any problem with the guide rail member 6c.

## Claims

1. An electronic appliance including a circuit board comprising:
a housing which carries an appearance of the appliance; and
a circuit board having mounted thereon a plurality of electronic parts disposed inside of the housing, wherein
a first holding portion for holding one side end of the circuit board is integrally formed in the housing, and
a second holding portion for holding the other side end of the circuit board is formed independently of the housing at a mount position opposed to the first holding portion in reference to a position at which the circuit board is disposed inside of the housing, the second holding portion enabled to change the mount position in a widthwise direction of the circuit board.

2. The electronic appliance including a circuit board according to claim 1,
wherein
a through hole is formed at a site at which the second holding portion is disposed in the housing, and
an engagement portion is formed to be engaged with the through hole of the housing at the second holding portion, the second holding portion enabled to be removably mounted in the housing.

3. The electronic appliance including a circuit board according to claim 2,
wherein a plurality of through holes to be formed in the housing are formed in the widthwise direction of the circuit board.

4. The electronic appliance including a circuit board according to claim 1, 2, or
3, wherein a guide groove in which a side end of the circuit board slidably moves is formed in a depth direction of the circuit board at the second holding portion.

5. The electronic appliance including a circuit board according to claim 1, 2, 3,
or 4, wherein the second holding portion is formed to be shorter in length than the first holding portion with respect to the depth direction of the circuit board disposed inside of the housing.
